# EUROPEAN PATENT SPECIFICATION

(11) **EP 3 822 047 B1**
(45) Date of publication and mention of the grant of the patent: **14.10.2026**
(21) Application number: 20205913.5
(22) Date of filing: 05.11.2020
(51) Int. Cl.: B25J 9/16, G01R 31/00, H05K 13/04

(54) **MEMORY INSERTION MACHINE**
SPEICHEREINFÜGUNGSMASCHINE
MACHINE D'INSERTION DE MÉMOIRE

(30) Priority: 14.11.2019 US 201916684069
(43) Date of publication of application: 19.05.2021
(73) Proprietor: Google LLC, Mountain View, CA 94043 (US)
(72) Inventor: REICHENBACH, Joseph, Mountain View, CA 94043 (US); XU, Toby, Mountain View, CA 94043 (US); GALLAGHER, Edward, Mountain View, CA 94043 (US); ZEVENBERGEN, John, Mountain View, CA 94043 (US)
(74) Representative: Betten & Resch

(56) References cited:
- CN-A- 110 027 015
- GB-A- 2 405 465
- KR-B1- 100 722 571
- US-A- 4 510 683
- US-A- 6 057 695
- US-A1- 2003 200 653
- US-A1- 2012 092 036
- US-B1- 8 035 408
- SASANKA L KANUPARTHI ET AL: "Impact of heatsink attach loading on FCBGA package thermal performance", THERMAL AND THERMOMECHANICAL PHENOMENA IN ELECTRONIC SYSTEMS (ITHERM), 2012 13TH IEEE INTERSOCIETY CONFERENCE ON, IEEE, 30 May 2012 (2012-05-30), pages 216 - 223, XP032453282, ISBN: 978-1-4244-9533-7, DOI: 10.1109/ITHERM.2012.6231433

## Description

### BACKGROUND

The proliferation of computing devices, such as web servers and workstations, has increased the demand for high speed memory. These computing devices require large amounts of high speed memory, such as DDR3 or DDR4, to operate at peak performance. Given the limited capacity of each memory module, these computing devices typically rely on several memory modules such as 16, 24, 32, or more memory modules to provide the high speed memory they require to operate. The proper installation of these memory modules into the computing devices is essential to ensuring the computing devices have access to all of the high speed memory they require. <INSERT DESCRIPTION PAGE 1A HERE>

### SUMMARY

The present invention is defined by independent claims 1 and 8. Advantageous embodiments are defined in the dependent claims. of
Document US 8 035 408 B1 discloses memory module test sockets, and more particularly memory-module test sockets for testing bent or warped modules.
Document US 6 057 695 A discloses a positioner for docking and undocking of an electronic test head with a device handler.
Document KR 100 722 571 B1 discloses a memory module insertion / removal device for holding an assembled memory module, and inserting and separating the same into / from a predetermined socket provided in a memory module test handler system.

### DESCRIPTION OF THE DRAWINGS

FIGURES 1A and 1B show a side view of insertion rods pushing a memory module into a memory socket mounted to a circuit board, in accordance with aspects of the disclosure.
FIGURE 2A shows a top-down view of the memory insertion machine in accordance with aspects of the disclosure.
FIGURE 2B shows a side view of the memory insertion machine in accordance with aspects of the disclosure.
FIGURE 3A shows a top-down view of movements of the memory insertion machine in accordance with aspects of the disclosure.
FIGURE 3B shows a side view of movements of the memory insertion machine in accordance with aspects of the disclosure.
FIGURE 4 shows a block diagram of an insertion controller in accordance with aspects of the disclosure.
FIGURE 5 illustrates an insertion pattern in accordance with aspects of the disclosure.
FIGURE 6A shows a side view of profilometer beam plane in accordance with aspects of the disclosure.
FIGURE 6B shows a top-down view of profilometer beam plane in accordance with aspects of the disclosure.
FIGURE 7 is an illustration of profilometer distance measurements in accordance with aspects of the disclosure.
FIGURE 8 is an illustration of a target distance measurement in accordance with aspects of the disclosure.
FIGURE 9 is a flow chart in accordance with one aspect of the disclosure.
FIGURE 10 is a graph showing operating parameters of the memory insertion machine in accordance with aspects of the disclosure.

### DETAILED DESCRIPTION

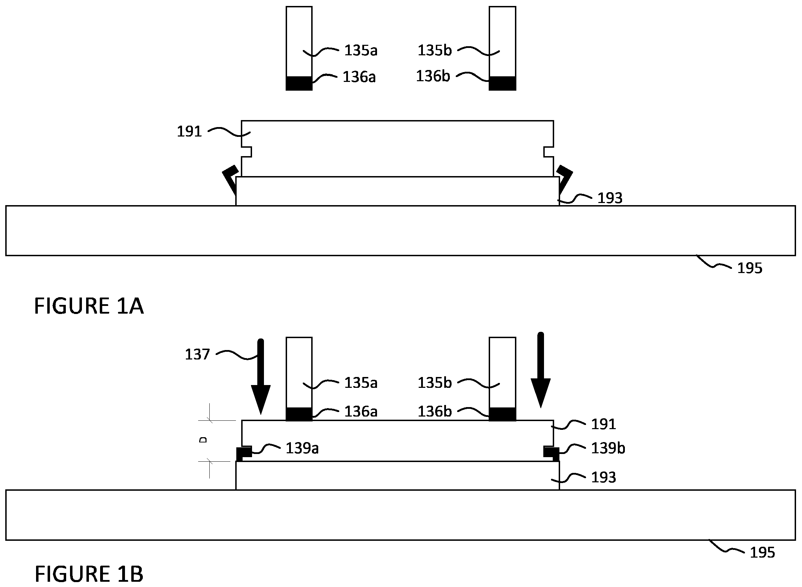

The technology relates generally to a device for inserting memory modules, such as Dual Inline Memory Modules (DIMM), into memory sockets. For example, and as illustrated in Figures 1A and 1B, the memory insertion machine includes insertion rods 135a and 135b for pushing a memory module 191 into a memory socket 193 mounted to a circuit board 195, such as a motherboard. The insertion rods 135a, 135b may push the memory module 191 into the memory socket 193 in the direction illustrated by the arrow 137 in Fig. 1b. The downward force applied by the insertion rods 135a, 135b may cause locking clips 139a and 139b to rotate towards, and secure the memory module 191 into the memory socket 193 when the memory module is fully inserted into the memory socket.

Measurements may be used to monitor the depth of insertion of the memory module 191 relative to the memory socket 193 as the insertion rods of the insertion system push the memory module 191 into the memory socket 193. In this regard, the insertion rods may continue to push the memory module into the memory socket until the relative distance from the top of the memory socket is a predetermined target distance 'D' from the top of the memory module 191. By inserting the memory module the target distance 'D', confidence that the memory module is properly seated in the memory socket, and therefore installed correctly, may be increased.

Manually installing memory modules may be labor intensive. In enterprise and manufacturing environments, hundreds, thousands, tens of thousands, or more memory modules may be installed. Systems which automate the installation process may decrease the installation time of memory modules, but both manual and automated installation may be prone to errors. These errors may include the use of too much force during insertion of a memory module into a memory socket, which may lead to broken components such as broken circuit boards, memory modules, and memory sockets. Moreover, improper installation of a memory module may lead to system failures or sub-par operation of the system. For example, memory modules which are not seated properly in a memory socket may cause the system to short-circuit. In some instances, improperly seated memory modules, that would otherwise be operational if seated properly, may be unavailable for use by the system. Additionally, troubleshooting improperly installed memory modules in systems that have a large number of memory modules may take a significant amount of time.

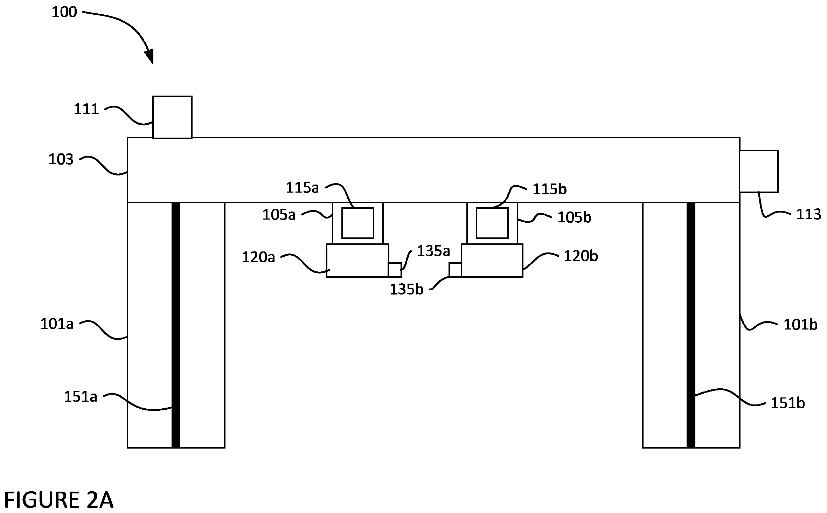

Figure 2A shows a top-down view of the memory insertion machine 100. The memory insertion machine 100 includes insertion rods 135a, 135b and profilometers 120a, 120b. The insertion rods 135a, 135b and profilometers 120a, 120b are mounted or otherwise attached to vertical guides 105a, 105b. Vertical guides 105a, 105b may be mounted or otherwise attached to horizontal guide 103, which in turn is mounted to a pair of guides 101a and 101b.

The guides, including the vertical guides 105a, 105b, the horizontal guide 103, and the pair of guides 101a, 101b may include guide slots, tracks, or other such guiding elements for positioning other guides, insertion rods, or profilometers. For instance, and as shown in Fig. 2A, each guide in the pair of guides 101a, 101b may include guide tracks 151a, 151b, respectively, in which opposing ends of the horizontal guide 103 may be moveably attached. In this regard, each of the opposing ends of the horizontal guide 103 may include a carriage or other such device that connects to guide tracks in the pair of guides 101a, 101b. Although the guide tracks 151a, 1151b are shown as being on the top surface of each guide in the pair of guides, the guide tracks may be on any surface of the pair of guides, such as the sides or bottom.

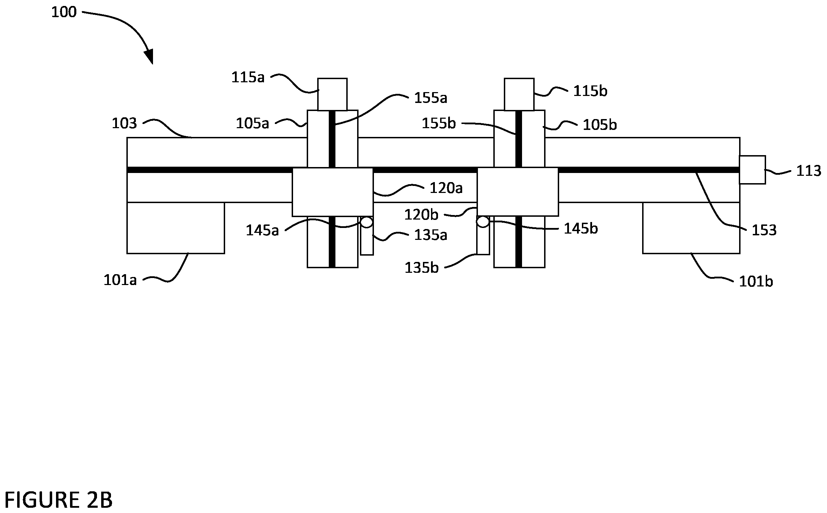

Fig. 2B shows a front view of the memory insertion machine 100, including a guide track 153 on the horizontal guide 103 and guide tracks 155a and 155b on the vertical guides 105a and 105b, respectively. The vertical guides 105a and 105b may be movably connected to the guide track 153 on the horizontal guide 103. Profilometers 120a and 120b may each be moveably connected to a guide track of the vertical guides 105a and 105b, respectively. Although Figs. 2A and 2B illustrate the insertion rods 135a, 135b being connected to the profilometers 120a, 120b, the insertion rods may be directly connected to guide tracks of the vertical guides or connected to the guide tracks of the vertical guides through intermediary connectors or other such devices.

Movement of the guides, insertion rods, and profilometers are implemented by drive units, such as servo motors, actuators including screw and belt driven actuators, or other such devices capable of controlling movements. For example, a first motor 111 is configured to control movement of the horizontal guide 103 along the guide tracks 151a, 151b of the pair of guides, as shown in Fig. 2A. A second motor 113 is configured to control movement of the vertical guides 105a, 105b along the guide track 153 of the horizontal guide. Movement of the insertion rods 135a, 135b and profilometers 120a, 120b on the guide tracks 155a, 155b of the vertical guides 105a, 105b, respectively, may be controlled by additional motors 115a, 115b, as shown in Fig. 2B.

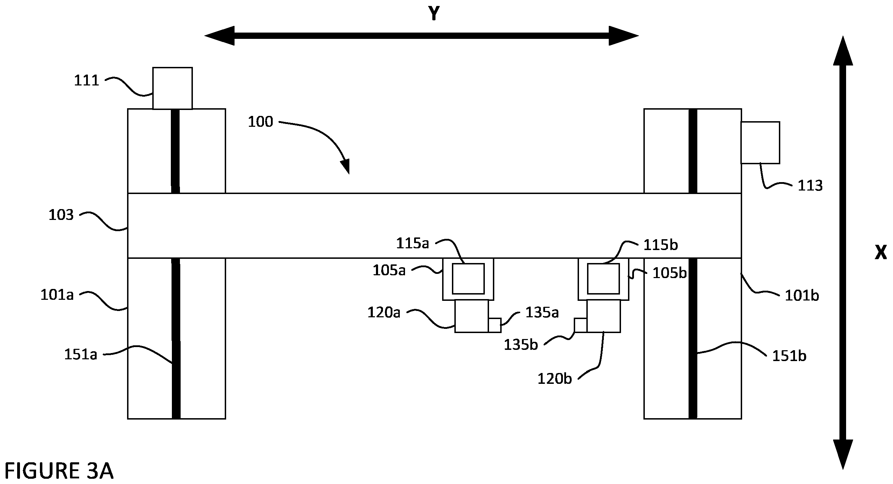

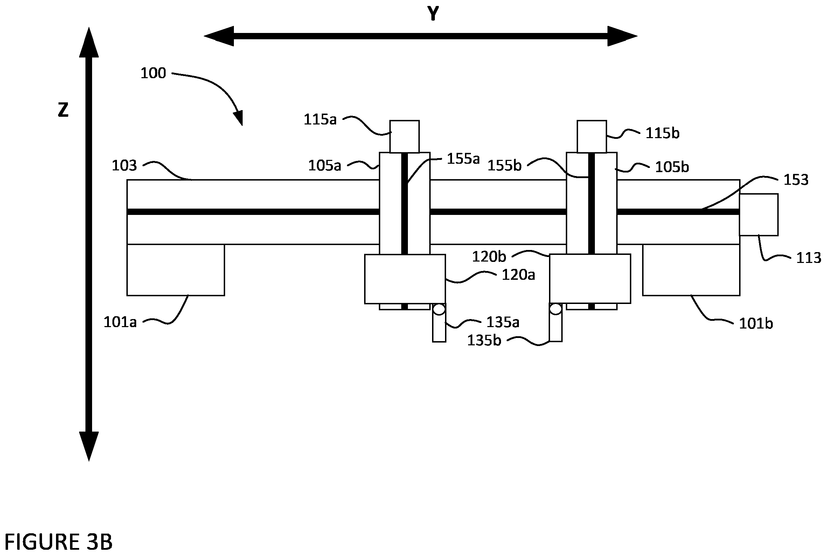

Example movements of the guides, insertion rods, and profilometers, relative to the positions shown in Figs. 2A and 2B, are shown in Figs. 3A and 3B, respectively. Turning to Fig. 3A, the first motor 11 is configured to move the horizontal guide 103 along the guides tracks 151a, 151b of the pair of guides 101a, 101b in the X direction.

As shown in Fig. 3B, the second motor 113 is configured to move the vertical guides 105a, 105b along the guide track 153 of the horizontal guide 103 in the Y direction. Additional motors 115a, 115b are configured to move the profilometers 120a, 120b and insertion rods 135a, 135b along the guide tracks 155a, 155b of the vertical guides 105a, 105b along the Z direction. Although both the profilometers 120a, 120b and insertion rods 135a, 135b are shown moving along the Z direction in Fig. 3B, the profilometers may remain stationary along the Z direction.

The insertion rods 135a, 135b may be made of a metal, such as steel, aluminum, etc., or some other material such as plastic, wood, etc. The shape of the insertion rods may be round, square, rectangular, or any other shape. The tips of the insertion rods that contact the memory modules may include a relatively soft material to minimize the risk of damage to the memory module. For instance, and as shown in Figs. 1A and 1B, the tips of insertion rods 135a and 135b are coated in a rubber material 136a and 136b, respectively.

The insertion rods 135a, 135b may be configured to push a memory module 191 from opposite sides into a memory socket 193, as shown in Fig. 1B. In this regard, the insertion rods 135a, 135b may be configured to push down on opposite sides of the memory module 191 with relatively even force so that the memory module remains in alignment with the memory socket 193 during insertion. Although two insertion rods are shown, one insertion rod, three insertion rods, or more may be included on the memory insertion machine.

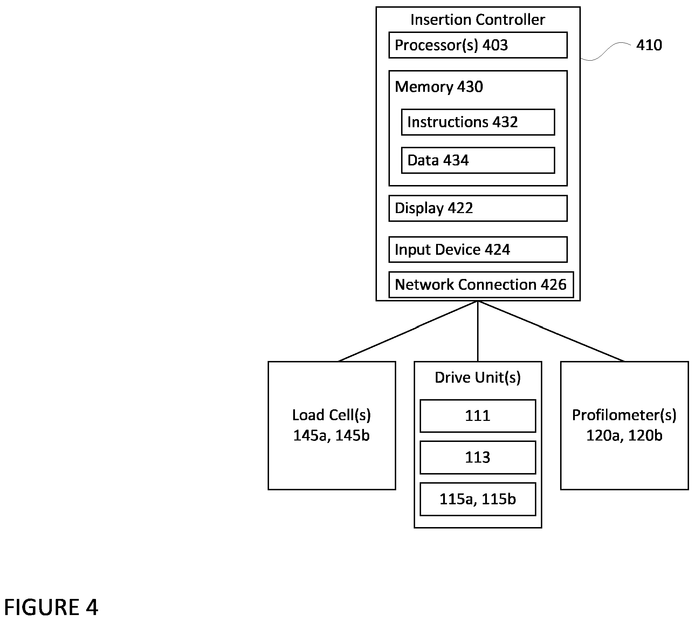

The operation of the memory insertion system 100 is controlled by an insertion controller 410, shown in Fig. 4. The insertion controller 410 may include a processor 403 and memory 430. The processor may be any conventional processor, such as processors from Intel Corporation or Advanced Micro Devices. Alternatively, the processor may be a dedicated controller such as an application specific integrated circuit (ASIC), field programmable gate array (FPGA), etc. Additionally, the processor 403 may include multiple processors, multi-core processors, or a combination thereof. Although only one processor 403 is shown in FIG. 4, one of ordinary skill in the art would recognize that several processors may exist within insertion controller 410. Accordingly, references to a processor will be understood to include references to a collection of processors or dedicated logic that may or may not operate in parallel.

The memory 430 stores information accessible by the one or more processors 403, including instructions 432 and data 434 that may be executed or otherwise used by the processor 403. The memory 430 may be of any type capable of storing information accessible by the processor, including a computing device-readable medium, or other medium that stores data that may be read with the aid of an electronic device, such as a hard-drive, memory card, ROM, RAM, DVD or other optical disks, as well as other write-capable and read-only memories. Systems and methods may include different combinations of the foregoing, whereby different portions of the instructions and data are stored on different types of media.

The instructions 432 may be any set of instructions to be executed directly (such as machine code) or indirectly (such as scripts) by the processor. For example, the instructions may be stored as computing device code on the computing device-readable medium. In that regard, the terms "instructions" and "programs" may be used interchangeably herein. The instructions may be stored in object code format for direct processing by the processor, or in any other computing device language including scripts or collections of independent source code modules that are interpreted on demand or compiled in advance. Functions, methods and routines of the instructions are explained in more detail below.

The data 434 may be retrieved, stored or modified by processor 403 in accordance with the instructions 432. For instance, although the claimed subject matter is not limited by any particular data structure, the data may be stored in computing device registers, in a relational database as a table having a plurality of different fields and records, XML documents or flat files. The data may also be formatted in any computing device-readable format.

The insertion controller 410 may include all of the components normally used in connection with a computing device such as the processor and memory described above as well as an input device (e.g., a mouse, keyboard, touch screen, buttons, and/or microphone) and various electronic displays (e.g., a monitor having a screen or any other electrical device that is operable to display information). In this example, the insertion controller includes a display 422 as well as input device 424. In some instances, the display may be a touch screen display capable of operating as a user input. The input device 424 and/or display 422 may be used to receive a selection of a circuit board model into which memory modules are to be inserted by the memory insertion machine 100, as described herein.

The insertion controller 410 may also include one or more network connections 426 to facilitate communication with other computing and storage devices. The network connections 426 may include wired or wireless communication protocols such as Bluetooth, Bluetooth low energy (LE), cellular connections, as well as various configurations and protocols including the Internet, World Wide Web, intranets, virtual private networks, wide area networks, local networks, private networks using communication protocols proprietary to one or more companies, Ethernet, Wi-Fi and HTTP, and various combinations of the foregoing.

The insertion controller 410 may store in memory 430 position data of one or more circuit board models. The position data for each circuit board model may include the locations of memory sockets relative to a known location. For instance, the memory insertion machine 100 may have a known location where circuit boards are positioned relative to an initial starting position of the memory insertion machine 100. In some instances, the position data may be retrieved by the insertion controller 410 from another storage device, such as a networked attached storage device.

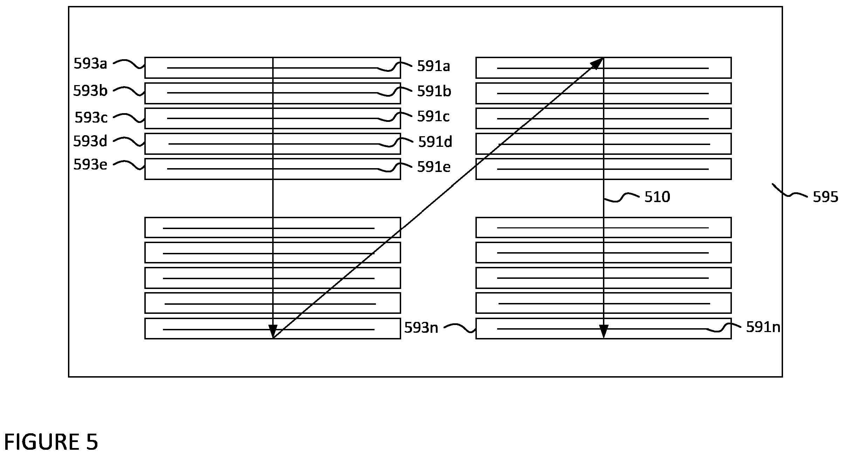

The insertion controller 410 may be configured to communicate with the drive units, such as motors 111, 113, 115a, and 115b to control the positioning of the guides, insertion rods, and profilometers relative to memory sockets on a circuit board. In this regard, based on the position data and known location, the insertion controller 410 may communicate with the drive units to position the insertion rods relative to the memory sockets on a circuit board and have the insertion rods push a memory module into the memory socket. This process may be repeated until memory modules are inserted into all memory sockets on the circuit board model. For example, on a circuit board 595 having 20 memory sockets 593a-593n, as shown in Fig. 5, the insertion controller 410 may control the memory insertion machine 100 such that it positions the insertion rods above memory modules 591a-591n positioned in memory sockets 593a-593n, respectively, in a programmed pattern 510. The pattern may be stored in association with the position data corresponding to the circuit board 595. According to pattern 510, the insertion controller 410 may control the drive units 111, 113, 115a, and 115b such that the insertion rods 135a, 135b of memory insertion machine 100 are positioned above memory socket 593a. When the insertion rods 135a, 135b are positioned above the memory socket 593a, the insertion rods 135a, 135b may push the memory module 591a into memory socket 593a. After memory module 591a is inserted, the insertion controller 410 may move the memory insertion machine 100 to a position relative to memory socket 593b. Memory module 591b may then be inserted into memory socket 593b. The memory insertion machine 100 may be moved according to pattern 510 until all memory modules are inserted into their respective memory sockets.

Referring again to Fig. 4, the insertion controller 410 may be configured to communicate with load cells 145a, 145b that measure the force applied by each insertion rod 135a, 135b. In this regard, a load cell may be mounted on or in the vicinity of an insertion rod. As the insertion rods 135a, 135b push a memory module into a memory socket, each load cell 145a, 145b may detect the force being applied by a respective insertion rod and forward the information to the insertion controller. For example, and as shown in Fig. 2B load cell 145a may monitor the force being applied by insertion rod 135a and load cell 145b may monitor the force being applied by insertion rod 135b.

The forces measured by the load cells may be provided to insertion controller 410. In the event the force measured by one or more of the load cells is greater than a threshold value, such as 155 N (35 pound-force), the insertion controller 410 may direct the drive units, such as motors 111, 113, 115a, and 115b, to cease movement of the insertion rods 135a, 135b and therefore prevent increases in forces applied to the memory module. By doing such, the risk of damage to the memory module, memory socket, and /or circuit board may be reduced. In some instances, the insertion controller 410 may cause the drive units to retract the insertion rods 135a, 135b away from the memory modules. Although only two load cells are shown in Fig. 2B, there may be any number of load cells. For instance, each insertion rod may have two or more load cells monitoring its insertion force. In examples where more than two insertion rods are present, there may be one or more load cells for each additional insertion rod.

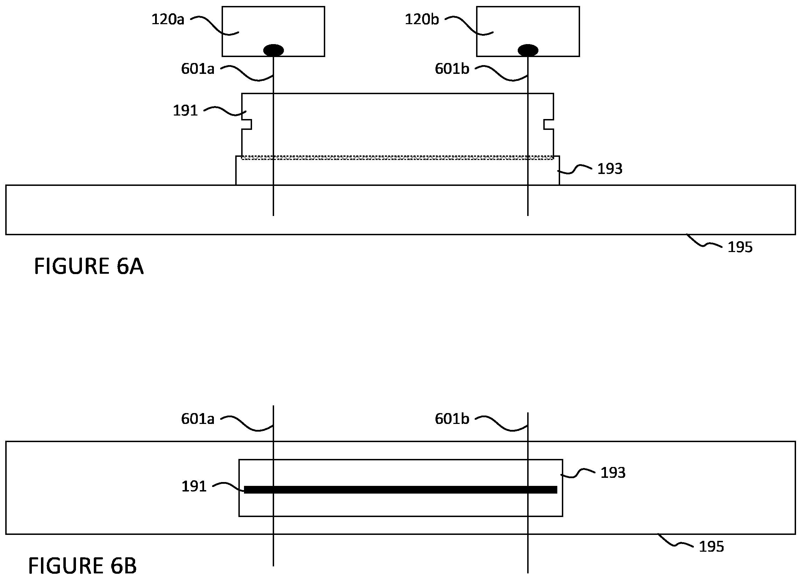

The profilometers 120a, 120b are configured to provide distance measurements between a memory module and a memory socket to the insertion controller 410. In this regard, the profilometers 120a, 120b may be positioned such that they can capture distance measurements for the memory module and the memory socket on opposite sides. For example, and as shown in the side view of memory socket 193 and circuit board 195 in Fig. 6A, profilometers 120a and 120b are positioned on opposite sides of memory module 191. By positioning the profilometers 120a, 120b on opposite sides of the memory module 191, the insertion distance of the memory module 191 into the memory socket 193 of circuit board 195 caused by each of the insertion rods may be monitored by the insertion controller 410. Although only two profilometers 120a and 120b are shown, the memory insertion machine 100 may include any number of profilometers.

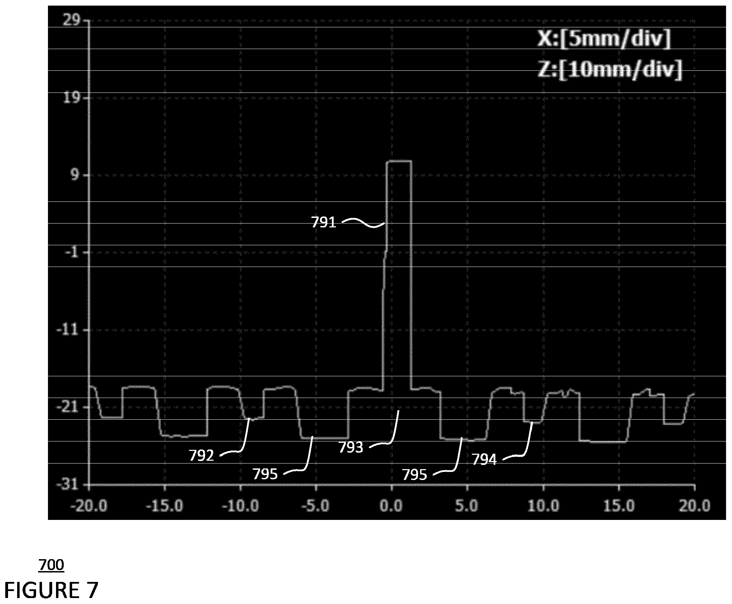

Each profilometer may transmit and receive a beam plane 601a and 601b, as shown in Figs. 6A and 6B. As shown in the top-down view of the memory socket 193 and circuit board 195 of Fig. 6B, the beam plane may capture data across the entirety of memory socket 193 on both sides of memory module 191. In some instances, the beam plane may capture data across multiple memory sockets at a time. For instance, Fig. 7 shows a visualization 700 of data captured by a profilometer across three memory sockets 792, 793, and 794 positioned on circuit board 795. A single memory module 791 is positioned in memory socket 793.

In some instances, the position of the profilometers may be dependent upon the circuit board model. In this regard, the profilometers may be prone to laser scatter due to reflective components on a circuit board, memory sockets, and memory modules. The location of such reflective components may be different for each circuit board model, as the position of components on each circuit board may be different. Additionally, the memory socket types, and memory module modules to be installed into the memory sockets, may be different between each circuit board model. To minimize laser scatter, positions of the profilometers 120a, 120b that have a low probability of suffering from laser scatter may be determined and stored in the memory 430 of insertion controller 410, or other storage device, in association with the positioning data of each circuit board model. In some embodiments, the positioning of the profilometers 120a, 120b on the Z direction, shown in Fig. 2B, may be increased or decreased independently of the insertion rods 135a, 135b to further minimize the risk of laser scatter. Stated another way, the profilometers may move independently of the insertion rods.

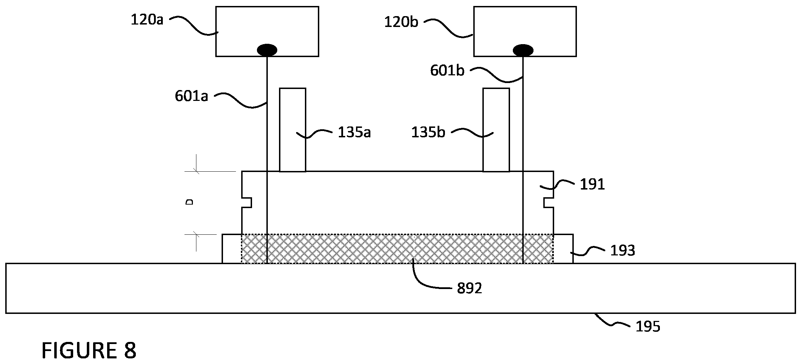

During insertion of a memory module into a memory socket, the insertion controller 410, using the distance measurements from the profilometers 120a, 120b, may measure the distance of the top of the memory module to the top of the memory socket. A target distance at which insertion of the memory module into the memory socket is completed may be stored in association with the positioning data of each circuit board model. The target distance may correspond to a distance that is known to result in proper seating and installation of the memory module in the memory socket. For example, Fig. 8 shows memory module 191 being inserted into memory socket 193 of circuit board 195 by insertion rods 135a and 135b. As the insertion rods 135a and 135b insert the memory module 191 into the memory socket 193, distance measurements provided by the beam planes 601a and 601b of profilometers 120a and 120b, respectively, may be provided to insertion controller 410. Once the insertion controller 410 detects the distance from the top of the memory socket 193 and the top of the memory module 191 is equal to the target distance 'D', the insertion of the memory module 191 may be completed and the insertion controller 410 may cause insertion rods 135a and 135 to stop applying further force to memory module 191. The portion of the memory module 191 inside of the memory socket 193 is shown by shaded portion 892.

By using the distance between the top of the memory socket and the top of the memory module, the risk of faulty installation of the memory module is reduced as the relative distance between the top of the memory socket and top of the memory module are dependent upon the distance of insertion of the memory module into the memory socket. Other measurements, such as the distance from the top of the memory module to the circuit board may be prone to false reading due to flexing of the circuit board during installation. Absolute readings, such as from the profilometer to the top of the memory module may also be prone to false readings due to flex of the circuit board, memory module, and/or memory socket during installation.

In addition to the operations described above and illustrated in the figures, various operations will now be described. The following operations do not have to be performed in the precise order described below. Rather, various steps can be handled in a different order or simultaneously, and steps may also be added or omitted.

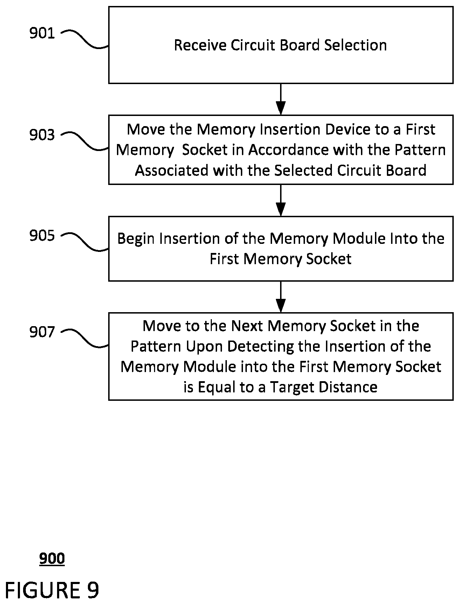

Figure 9 illustrates a flow chart 900 showing an example memory insertion operation of the memory insertion machine 100. As shown in block 901, the memory insertion machine 100 may receive a selection of a circuit board model via an input or command, such as a selection on input device 424. Based on the selection, the insertion controller is configured to control the memory insertion machine 100 such that it pushes each memory module into a memory socket. In this regard, the insertion controller 410 may control the various drive units, including motors 111, 113, 115a, and 115b, such that they move the memory insertion machine in accordance with a pattern corresponding to the selected circuit board model, starting with a first memory socket as shown in block 903.

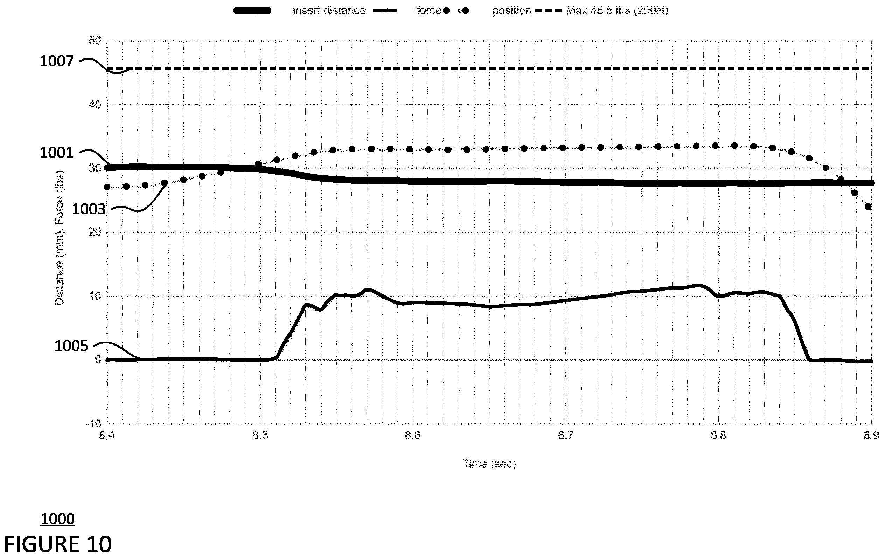

At each memory socket, the memory insertion machine 100 may insert a memory module into the memory socket. For instance, at the first memory socket, the memory insertion machine 100 may begin insertion of a memory module in the first memory socket, as shown in block 905. During insertion, the insertion controller 410 may monitor operating parameters as shown in chart 1000 of Fig. 10. For instance, the insertion controller may measure the insertion distance 1001 of the memory module relative to the memory socket into which it is being inserted based on distance measurements provided by the profilometers 120a, 120b. The insertion controller 410 may control the memory insertion machine 100 and advance the insertion rods and other components of the memory insertion machine to the next memory module in the pattern once the distance of the first memory module in the first memory socket reaches a target distance 'D', as shown in block 907.

The insertion controller may also monitor the force 1003 being applied by each insertion rod 135a, 135b to a memory module. Depending on the amount of force being applied, as measured by the load cells 145a, 145b, the insertion controller may slow down or speed up the insertion speed. For instance, and as further shown in Fig. 10, the insertion controller 410 may have the insertion rods 135a, 135b move at a speed of 50 mm/sec when force 1005 is below a threshold value and 2mm/sec when force is above a threshold value, such as 22 N (5 pound-force). As previously described, in the event the force exceeds a maximum value 1007, such as 202 N (45.5 pound-force), the insertion controller 410 may direct the drive units 111, 113, 115a, and/or 115b to cease movement of the insertion rods 135a, 135b and therefore prevent increases in forces applied to the memory module. In some instances, the insertion controller 410 may cause the drive units to retract the insertion rods away from the memory modules. The speed and positioning of each insertion rod 135a, 135b may be independently controlled to maintain the memory module in a parallel positon with the memory socket.

Although the technology herein has been described with reference to particular embodiments, it is to be understood that these embodiments are merely illustrative of the principles and applications of the present technology. It is therefore to be understood that numerous modifications may be made to the illustrative embodiments and that other arrangements may be devised without departing from the scope of the present technology as defined by the appended claims.

## Claims

1. A memory insertion machine (100) comprising:
one or more insertion rods (135a, 135b), including a first insertion rod (135a) and a second insertion rod (135b), wherein the first insertion rod (135a) is moveably mounted to a first vertical guide (105a) and the second insertion rod (135b) is movably mounted to a second vertical guide (105b);
a horizontal guide (103);
a pair of guides (101a, 101b), wherein a first end of the horizontal guide (103) is connected to one of the pair of guides (101a, 101b) and a second, opposite end of the horizontal guide (103) is connected to a second of the pair of guides (101a, 101b), wherein the first and second vertical guides (105a, 105b) are connected to the horizontal guide (103);
a first motor (111) configured to move the horizontal guide (103) along a pair of guide tracks (151a, 151b) on the pair of guides (101a, 101b);
a second motor (113) configured to move the first and second vertical guides (105a, 105b) along a guide track (153) in the horizontal guide (103);
one or more profilometers (120a, 20b) configured to measure a distance between a top of a memory module and a top of a memory socket;
a third motor (115a) and a fourth motor (115b) configured to move the one or more profilometers (120a, 120b) and the first and second insertion rods (135a, 135b) along guide tracks (155a, 155b) in the first and second vertical guides (105a, 105b); and
an insertion controller (410), comprising an input device (424) configured to receive a selection of a circuit board model, wherein the circuit board model is associated with position data indicating locations of a plurality of memory sockets (193) on a circuit board relative to a known location;
wherein the insertion controller (410) is configured to:
position, based on the position data and known location, the first and second insertion rods (135a, 135b) above a memory socket (193) of the plurality of memory sockets (193);
apply, by controlling movement of the first insertion rod (135a) on the first vertical guide (105a) and the second insertion rod (135b) on the second vertical guide (105b), an insertion force to the memory module (191) in the memory socket (193);
determine, based on information received from the one or more profilometers (120a, 120b), a measured distance between the top of the memory module (191) and the top of the memory socket (193); and
cease applying the insertion force by the first and second insertion rods (135a, 135b) when the measured distance matches a predetermined target distance.

2. The memory insertion machine (100) of claim 1, further comprising:
one or more load cells (145a, 145b), wherein the one or more load cells (145a, 145b) measure the insertion force applied to the memory module (191) by the first and second insertion rods (135a, 135b).

3. The memory insertion machine (100) of claim 2, wherein the insertion force includes individual insertion forces applied by each of the first and second insertion rods (135a, 135b), and the individual insertion forces are each measured by different load cells (145a, 145b) of the one or more load cells (145a, 145b).

4. The memory insertion machine (100) of claim 2 or 3, wherein the insertion controller (410) is further configured to retract the first and second insertion rods (135a, 135b) when the insertion force applied by at least one of the first and second insertion rods (135a, 135b) is greater than a threshold value; and wherein the threshold value preferably is 202 N (45.5 pound-force).

5. The memory insertion machine (100) of claim 1, wherein the insertion controller (410) is further configured to position the first and second insertion rods (135a, 135b) above the plurality of memory sockets (193) in a predefined pattern, based on the position data.

6. The memory insertion machine (100) of claim 5, wherein for each time the first and second insertion rods (135a, 135b) are positioned above a memory socket (193) of the plurality of memory sockets (193), the insertion controller (410) causes the first and second insertion rods (135a, 135b) to apply a force to a memory module (191) positioned in the respective memory socket (193) until the measured distance between the top of the respective memory socket (193) and the top of the memory module (191) matches the predetermined target distance.

7. The memory insertion machine (100) of one of claims 1 to 6, wherein the insertion controller (410) is further configured to control an insertion speed of the memory module (191) by controlling the insertion force applied by the first and second insertion rods (135a, 135b); and
wherein the insertion speed preferably is adjusted based on the insertion force applied by the first and second insertion rods (135a, 135b).

8. A method for inserting one or more memory modules (191) into one or more memory sockets (193) with the memory insertion machine (100) according to claim 1, the method comprising:
positioning, by the insertion controller (410), based on the position data and known location, the first and second insertion rods (135a, 135b) above a memory socket (193) of the plurality of memory sockets (193),
applying, by controlling movement of the first insertion rod (135a) on the first vertical guide (105a) and the second insertion rod (135b) on the second vertical guide (105b) by the insertion controller (410), an insertion force to a memory module (191) in the memory socket (193);
measuring, by the one or more profilometers (120a, 120b), a distance between a top of the memory module (191) and a top of the memory socket (193); and
controlling, by the insertion controller (410), the insertion force applied to the memory module (191) by the first and second insertion rods (135a, 135b) based on the measured distance, the insertion controller (410) configured to cease applying the insertion force by the first and second insertion rods (135a, 135b) when the measured distance matches a target distance.

9. The method of claim 8, further comprising:
measuring, by one or more load cells (145a, 145b), the insertion force applied to the memory module (191) by the first and second insertion rods (135a, 135b).

10. The method claim 9, wherein the insertion force includes a first insertion force applied by the first insertion rod (135a) and a second insertion force applied by the second insertion rod (135b), wherein the first insertion force and the second insertion force are each measured by a respective one of the one or more load cells (145a, 145b); and/or
further comprising:
retracting, by the insertion controller (410), the first and second insertion rods (135a, 135b) when the insertion force applied by one or more of the first and second insertion rods (135a, 135b) is greater than a threshold value.

## Patentansprüche

1. Speichereinfügungsmaschine (100), umfassend:
eine oder mehrere Einfügungsstangen (135a, 135b), einschließlich einer ersten Einfügungsstange (135a) und einer zweiten Einfügungsstange (135b), wobei die erste Einfügungsstange (135a) beweglich an einer ersten vertikalen Führung (105a) montiert ist und die zweite Einfügungsstange (135b) beweglich an einer zweiten vertikalen Führung (105b) montiert ist;
eine horizontale Führung (103);
ein Paar von Führungen (101a, 101b), wobei ein erstes Ende der horizontalen Führung (103) mit einer des Paares von Führungen (101a, 101b) verbunden ist und ein zweites, gegenüberliegendes Ende der horizontalen Führung (103) mit einer zweiten des Paares von Führungen (101a, 101b) verbunden ist, wobei die erste und die zweite vertikale Führung (105a, 105b) mit der horizontalen Führung (103) verbunden sind;
einen ersten Motor (111), der konfiguriert ist, um die horizontale Führung (103) entlang eines Paares von Führungsschienen (151a, 151b) auf dem Paar von Führungen (101a, 101b) zu bewegen;
einen zweiten Motor (113), der konfiguriert ist, um die erste und die zweite vertikale Führung (105a, 105b) entlang einer Führungsschiene (153) in der horizontalen Führung (103) zu bewegen;
ein oder mehrere Profilometer (120a, 120b), die konfiguriert sind, um einen Abstand zwischen einer Oberseite eines Speichermoduls und einer Oberseite eines Speichersockels zu messen;
einen dritten Motor (115a) und einen vierten Motor (115b), die konfiguriert sind, um das eine oder die mehreren Profilometer (120a, 120b) und die erste und die zweite Einfügungsstange (135a, 135b) entlang von Führungsschienen (155a, 155b) in der ersten und der zweiten vertikalen Führung (105a, 105b) zu bewegen; und
eine Einfügungssteuerung (410), umfassend eine Eingabevorrichtung (424), die konfiguriert ist, um eine Auswahl eines Schaltungsplattenmodells zu empfangen, wobei das Schaltungsplattenmodell mit Positionsdaten verknüpft ist, die Orte einer Mehrzahl von Speichersockeln (193) auf einer Schaltungsplatte relativ zu einem bekannten Ort angeben;
wobei die Einfügungssteuerung (410) konfiguriert ist, um:
basierend auf den Positionsdaten und dem bekannten Ort die erste und die zweite Einfügungsstange (135a, 135b) über einem Speichersockel (193) der Mehrzahl von Speichersockeln (193) zu positionieren;
durch Steuern der Bewegung der ersten Einfügungsstange (135a) auf der ersten vertikalen Führung (105a) und der zweiten Einfügungsstange (135b) auf der zweiten vertikalen Führung (105b) eine Einfügungskraft auf das Speichermodul (191) in dem Speichersockel (193) aufzubringen;
basierend auf Informationen, die von dem einen oder den mehreren Profilometern (120a, 120b) empfangen werden, einen gemessenen Abstand zwischen der Oberseite des Speichermoduls (191) und der Oberseite des Speichersockels (193) zu bestimmen; und
das Aufbringen der Einfügungskraft durch die erste und die zweite Einfügungsstange (135a, 135b) zu beenden, wenn der gemessene Abstand einem vorbestimmten Zielabstand entspricht.

2. Speichereinfügungsmaschine (100) nach Anspruch 1, ferner umfassend:
eine oder mehrere Kraftmessdosen (145a, 145b), wobei die eine oder die mehreren Kraftmessdosen (145a, 145b) die Einfügungskraft messen, die auf das Speichermodul (191) durch die erste und die zweite Einfügungsstange (135a, 135b) aufgebracht wird.

3. Speichereinfügungsmaschine (100) nach Anspruch 2, wobei die Einfügungskraft einzelne Einfügungskräfte einschließt, die von jeder der ersten und der zweiten Einfügungsstange (135a, 135b) aufgebracht werden, und die einzelnen Einfügungskräfte jeweils durch unterschiedliche Kraftmessdosen (145a, 145b) der einen oder der mehreren Kraftmessdosen (145a, 145b) gemessen werden.

4. Speichereinfügungsmaschine (100) nach Anspruch 2 oder 3, wobei die Einfügungssteuerung (410) ferner konfiguriert ist, um die erste und die zweite Einfügungsstange (135a, 135b) zurückzuziehen, wenn die Einfügungskraft, die von mindestens einer der ersten und der zweiten Einfügungsstange (135a, 135b) aufgebracht wird, größer als ein Schwellenwert ist; und
wobei der Schwellenwert vorzugsweise 202 N (45,5 Pfund-Kraft) beträgt.

5. Speichereinfügungsmaschine (100) nach Anspruch 1, wobei die Einfügungssteuerung (410) ferner konfiguriert ist, um die erste und die zweite Einfügungsstange (135a, 135b) über der Mehrzahl von Speichersockeln (193) in einem vordefinierten Muster zu positionieren, basierend auf den Positionsdaten.

6. Speichereinfügungsmaschine (100) nach Anspruch 5, wobei für jedes Mal, wenn die erste und die zweite Einfügungsstange (135a, 135b) über einem Speichersockel (193) der Mehrzahl von Speichersockeln (193) positioniert werden, die Einfügungssteuerung (410) die erste und die zweite Einfügungsstange (135a, 135b) veranlasst, eine Kraft auf ein in dem jeweiligen Speichersockel (193) positioniertes Speichermodul (191) aufzubringen, bis der gemessene Abstand zwischen der Oberseite des jeweiligen Speichersockels (193) und der Oberseite des Speichermoduls (191) dem vorbestimmten Zielabstand entspricht.

7. Speichereinfügungsmaschine (100) nach einem der Ansprüche 1 bis 6, wobei die Einfügungssteuerung (410) ferner konfiguriert ist, um eine Einfügungsgeschwindigkeit des Speichermoduls (191) durch Steuern der von der ersten und der zweiten Einfügungsstange (135a, 135b) aufgebrachten Einfügungskraft zu steuern; und
wobei die Einfügungsgeschwindigkeit vorzugsweise basierend auf der Einfügungskraft angepasst wird, die von der ersten und der zweiten Einfügungsstange (135a, 135b) aufgebracht wird.

8. Verfahren zum Einfügen eines oder mehrerer Speichermodule (191) in einen oder mehrere Speichersockel (193) mit der Speichereinfügungsmaschine (100) nach Anspruch 1, wobei das Verfahren Folgendes umfasst:
Positionieren, durch die Einfügungssteuerung (410), basierend auf den Positionsdaten und dem bekannten Ort, der ersten und der zweiten Einfügungsstange (135a, 135b) über einem Speichersockel (193) der Mehrzahl von Speichersockeln (193),
Aufbringen, durch Steuern der Bewegung der ersten Einfügungsstange (135a) auf der ersten vertikalen Führung (105a) und der zweiten Einfügungsstange (135b) auf der zweiten vertikalen Führung (105b) durch die Einfügungssteuerung (410), einer Einfügungskraft auf ein Speichermodul (191) in dem Speichersockel (193);
Messen, durch das eine oder die mehreren Profilometer (120a, 120b), eines Abstands zwischen einer Oberseite des Speichermoduls (191) und einer Oberseite des Speichersockels (193); und Steuern, durch die Einfügungssteuerung (410), der auf das Speichermodul (191) durch die erste und die zweite Einfügungsstange (135a, 135b) aufgebrachten Einfügungskraft basierend auf dem gemessenen Abstand, wobei die Einfügungssteuerung (410) konfiguriert ist, um das Aufbringen der Einfügungskraft durch die erste und die zweite Einfügungsstange (135a, 135b) zu beenden, wenn der gemessene Abstand einem Zielabstand entspricht.

9. Verfahren nach Anspruch 8, ferner umfassend:
Messen, durch eine oder mehrere Kraftmessdosen (145a, 145b), der Einfügungskraft, die auf das Speichermodul (191) durch die erste und die zweite Einfügungsstange (135a, 135b) aufgebracht wird.

10. Verfahren nach Anspruch 9, wobei die Einfügungskraft eine erste Einfügungskraft, die von der ersten Einfügungsstange (135a) aufgebracht wird, und eine zweite Einfügungskraft, die von der zweiten Einfügungsstange (135b) aufgebracht wird, einschließt, wobei die erste Einfügungskraft und die zweite Einfügungskraft jeweils von einer jeweiligen der einen oder mehreren Kraftmessdosen (145a, 145b) gemessen werden; und/oder
ferner umfassend:
Zurückziehen, durch die Einfügungssteuerung (410), der ersten und der zweiten Einfügungsstange (135a, 135b), wenn die Einfügungskraft, die von einer oder mehreren der ersten und der zweiten Einfügungsstange (135a, 135b) aufgebracht wird, größer als ein Schwellenwert ist.

## Revendications

1. Machine d'insertion de mémoire (100) comprenant :
une ou plusieurs tiges d'insertion (135a, 135b), comportant une première tige d'insertion (135a) et une seconde tige d'insertion (135b), dans laquelle la première tige d'insertion (135a) est montée de manière mobile sur un premier guide vertical (105a) et la seconde tige d'insertion (135b) est montée de manière mobile sur un second guide vertical (105b) ;
un guide horizontal (103) ;
une paire de guides (101a, 101b), dans laquelle une première extrémité du guide horizontal (103) est reliée à l'un des guides de la paire de guides (101a, 101b) et une seconde extrémité opposée du guide horizontal (103) est reliée à un second guide de la paire de guides (101a, 101b), dans laquelle les premier et second guides verticaux (105a, 105b) sont reliés au guide horizontal (103) ;
un premier moteur (111) configuré pour déplacer le guide horizontal (103) le long d'une paire de rails de guidage (151a, 151b) sur la paire de guides (101a, 101b) ;
un deuxième moteur (113) configuré pour déplacer les premier et second guides verticaux (105a, 105b) le long d'un rail de guidage (153) dans le guide horizontal (103) ;
un ou plusieurs profilomètres (120a, 120b) configurés pour mesurer une distance entre le haut d'un module de mémoire et le haut d'un support de mémoire ;
un troisième moteur (115a) et un quatrième moteur (115b) configurés pour déplacer les un ou plusieurs profilomètres (120a, 120b) et les première et seconde tiges d'insertion (135a, 135b) le long de rails de guidage (155a, 155b) dans les premier et second guides verticaux (105a, 105b) ; et
un dispositif de commande d'insertion (410), comprenant un dispositif d'entrée (424) configuré pour recevoir une sélection d'un modèle de carte de circuit imprimé, dans laquelle le modèle de carte de circuit imprimé est associé à des données de position indiquant les emplacements d'une pluralité de supports de mémoire (193) sur une carte de circuit imprimé par rapport à un emplacement connu ;
dans laquelle le dispositif de commande d'insertion (410) est configuré pour :
positionner, sur la base des données de position et de l'emplacement connu, les première et seconde tiges d'insertion (135a, 135b) au-dessus d'un support de mémoire (193) de la pluralité de supports de mémoire (193) ;
appliquer, en commandant le déplacement de la première tige d'insertion (135a) sur le premier guide vertical (105a) et de la seconde tige d'insertion (135b) sur le second guide vertical (105b), une force d'insertion au module de mémoire (191) dans le support de mémoire (193) ;
déterminer, sur la base des informations reçues des un ou plusieurs profilomètres (120a, 120b), une distance mesurée entre le haut du module de mémoire (191) et le haut du support de mémoire (193) ; et
cesser d'appliquer la force d'insertion par les première et seconde tiges d'insertion (135a, 135b) lorsque la distance mesurée correspond à une distance cible prédéterminée.

2. Machine d'insertion de mémoire (100) selon la revendication 1, comprenant en outre :
une ou plusieurs cellules de charge (145a, 145b), dans laquelle les une ou plusieurs cellules de charge (145a, 145b) mesurent la force d'insertion appliquée au module de mémoire (191) par les première et seconde tiges d'insertion (135a, 135b).

3. Machine d'insertion de mémoire (100) selon la revendication 2, dans laquelle la force d'insertion comporte des forces d'insertion individuelles appliquées par chacune des première et seconde tiges d'insertion (135a, 135b), et les forces d'insertion individuelles sont chacune mesurées par différentes cellules de charge (145a, 145b) des une ou plusieurs cellules de charge (145a, 145b).

4. Machine d'insertion de mémoire (100) selon la revendication 2 ou 3, dans laquelle le dispositif de commande d'insertion (410) est en outre configuré pour rétracter les première et seconde tiges d'insertion (135a, 135b) lorsque la force d'insertion appliquée par au moins l'une des première et seconde tiges d'insertion (135a, 135b) est supérieure à une valeur seuil ; et dans laquelle la valeur seuil est de préférence de 202 N (45,5 livres-force).

5. Machine d'insertion de mémoire (100) selon la revendication 1, dans laquelle le dispositif de commande d'insertion (410) est en outre configuré pour positionner les première et seconde tiges d'insertion (135a, 135b) au-dessus de la pluralité de supports de mémoire (193) selon un motif prédéfini, sur la base des données de position.

6. Machine d'insertion de mémoire (100) selon la revendication 5, dans laquelle, à chaque fois que les première et seconde tiges d'insertion (135a, 135b) sont positionnées au-dessus d'un support de mémoire (193) parmi la pluralité de supports de mémoire (193), le dispositif de commande d'insertion (410) fait en sorte que les première et seconde tiges d'insertion (135a, 135b) appliquent une force à un module de mémoire (191) positionné dans le support de mémoire (193) respectif jusqu'à ce que la distance mesurée entre le haut du support de mémoire (193) respectif et le haut du module de mémoire (191) corresponde à la distance cible prédéterminée.

7. Machine d'insertion de mémoire (100) selon l'une des revendications 1 à 6, dans laquelle le dispositif de commande d'insertion (410) est en outre configuré pour commander la vitesse d'insertion du module de mémoire (191) en commandant la force d'insertion appliquée par les première et seconde tiges d'insertion (135a, 135b) ; et
dans laquelle la vitesse d'insertion est de préférence ajustée sur la base de la force d'insertion appliquée par les première et seconde tiges d'insertion (135a, 135b).

8. Procédé d'insertion d'un ou plusieurs modules de mémoire (191) dans un ou plusieurs supports de mémoire (193) à l'aide de la machine d'insertion de mémoire (100) selon la revendication 1, le procédé comprenant :
le positionnement, par le dispositif de commande d'insertion (410), sur la base des données de position et de l'emplacement connu, des première et seconde tiges d'insertion (135a, 135b) au-dessus d'un support de mémoire (193) de la pluralité de supports de mémoire (193),
l'application, en commandant le déplacement de la première tige d'insertion (135a) sur le premier guide vertical (105a) et de la seconde tige d'insertion (135b) sur le second guide vertical (105b), par le dispositif de commande d'insertion (410), d'une force d'insertion à un module de mémoire (191) dans le support de mémoire (193) ;
la mesure, par les un ou plusieurs profilomètres (120a, 120b), de la distance entre le haut du module de mémoire (191) et le haut du support de mémoire (193) ; et
la commande, par le dispositif de commande d'insertion (410), de la force d'insertion appliquée au module de mémoire (191) par les première et seconde tiges d'insertion (135a, 135b) sur la base de la distance mesurée, le dispositif de commande d'insertion (410) étant configuré pour cesser d'appliquer la force d'insertion par les première et seconde tiges d'insertion (135a, 135b) lorsque la distance mesurée correspond à une distance cible.

9. Procédé selon la revendication 8, comprenant en outre :
la mesure, par une ou plusieurs cellules de charge (145a, 145b), de la force d'insertion appliquée au module de mémoire (191) par les première et seconde tiges d'insertion (135a, 135b).

10. Procédé selon la revendication 9, dans lequel la force d'insertion comporte une première force d'insertion appliquée par la première tige d'insertion (135a) et une seconde force d'insertion appliquée par la seconde tige d'insertion (135b), dans lequel la première force d'insertion et la seconde force d'insertion sont chacune mesurées par une cellule de charge respective des une ou plusieurs cellules de charge (145a, 145b) ; et/ou
comprenant en outre :
la rétractation, par le dispositif de commande d'insertion (410), des première et seconde tiges d'insertion (135a, 135b) lorsque la force d'insertion appliquée par une ou plusieurs des première et seconde tiges d'insertion (135a, 135b) est supérieure à une valeur seuil.
